**Europäisches Patentamt**

**European Patent Office**

**Office européen des brevets**

(11) Veröffentlichungsnummer: **0 084 077**
**B1**

(12) **EUROPÄISCHE PATENTSCHRIFT**

(45) Veröffentlichungstag der Patentschrift:
27.08.86

(51) Int. Cl.⁴: **G 03 F 7/16**

(21) Anmeldenummer: **82102260.5**

(22) Anmeldetag: **19.03.82**

(54) Vorrichtung zum automatischen Beschicken von Trägerplatten für gedruckte Schaltungen, an eine Filmaufwalzeinrichtung.

(30) Priorität: **07.01.82 IT 1902582**

(43) Veröffentlichungstag der Anmeldung:
**27.07.83 Patentblatt 83/30**

(45) Bekanntmachung des Hinweises auf die Patenterteilung:
**27.08.86 Patentblatt 86/35**

(84) Benannte Vertragsstaaten:
**AT BE CH DE FR GB LI LU NL SE**

(56) Entgegenhaltungen:
**DE - A - 2 402 701**
**US - A - 2 628 726**
**US - A - 4 275 809**

(73) Patentinhaber: **Curti, Ezio, Viale Regina Giovanna, 38, I-20100 Milano (IT)**

(72) Erfinder: **Curti, Ezio, Viale Regina Giovanna, 38, I-20100 Milano (IT)**

(74) Vertreter: **Mayer, Hans Benno, Via dell'Orso 7/A, I-20121 Milano (IT)**

ACTORUM AG

## Beschreibung

Die vorstehende Erfindung betrifft eine Vorrichtung zum automatischen Zuführen von Trägerplatten für gedruckte elektrische Schaltungen an eine nachfolgende Filmaufwalzeinrichtung.

Aus der US-A 2 628 726 ist eine Vorrichtung zum Greifen und Abheben von Metallplatten von einem Plattenstapel bekannt geworden. Bei dieser Vorrichtung sind pendelnd gelagerte Greifer vorgesehen, die mit, auf die Plattenenden gerichteten Ausnehmungen versehen sind, in die die Plattenränder eingreifen können, um somit ein Anheben der Platten über eine formschlüssige Wirkverbindung zu ermöglichen.

Eine derartige Vorrichtung ist für die automatische Beschicken von Trägerplatten für gedruckte Schaltungen an eine Filmauswalzeinrichtung nicht geeignet, da die hochempfindlichen Oberflächen der Platten bei Eindringen in die Ausnehmungen der Greifer beschädigt und somit unbrauchbar werden würden.

Aus der US-A 4 275 809 ist im wesentlichen eine Antriebsvorrichtung für einen Rollengang beschrieben, der zum Fördern von plattenförmigen Materialien, z. B. Trägerplatten für gedruckte elektronische Schaltungen geeignet ist. Zum Antrieb der Transportrollen ist ein Reibband vorgesehen, das auf den aussenliegenden Seiten der Transportrollen mit diesem in Wirkverbindung steht. Ein Anheben und automatisches Fördern der Trägerplatten, ohne mit den Flächen der Platte in Berührung zu kommen, ist mit dieser Vorrichtung nicht möglich.

Es ist bekannt, dass Trägerplatten für gedruckte Schaltungen, nachdem diese einer Säuberung, Waschung und Trocknung unterzogen wurden und nachdem diese Platten aufgestapelt wurden, einer sogenannten Filmauftragseinrichtung zugeführt werden, in der auf die Trägerplatte ein Film aufgebracht wird, der zur Durchführung des bekannten Fotoresistverfahrens erforderlich ist.

Den Fachleuten auf dem einschlägigen Gebiet ist es bekannt, dass die Übertragung der Trägerplatten für gedruckte elektrische Schaltungen vom Stapel zur Filmaufwalzeinrichtung erhebliche Schwierigkeiten mit sich bringt, da die äusserst empfindlichen Oberflächen der Trägerplatte, die vorher gewaschen und getrocknet wurden, auf keinen Fall mechanisch beansprucht werden dürfen, und diese weder Kratzer noch Eindrücke oder Abdrücke aufweisen dürfen. Ferner dürfen diese Oberflächen auf keinen Fall mit der blossen Hand berührt werden, und auch der Einsatz von elastischen Transportsaugern (Gummi) ist nicht möglich, da entsprechende Abdrücke auf den Plattenflächen verbleiben würden, die zu einer mehr oder weniger ausgeprägten Verschmutzung der Plattenfläche führen würden, die nicht mehr die sichere Aufbringung des Films in der Walzeinrichtung erlauben würden. Somit werden auch heute noch Trägerplatten für gedruckte Schaltungen in einem absolut klimatisierten Raum von Hand, unter Einsatz zahlreicher Arbeitskräfte, die Schutzhandschuhe tragen, der Filmaufwalzeinrichtung zugeführt. Die Beschickung der Platten von Hand befriedigt natürlich nicht die Bedürfnisse einer modernen Grossserienfertigung und die ständige aufwendige Reinigung der klimatisierten Räume, sowie die Kosten für die Klimatisierung dieser Räume, erfordert erhebliche Investitionen, obwohl der Einsatz von Schutzhandschuhen vorgeschrieben ist (meist Baumwollhandschuhe), ist es häufig erforderlich, Trägerplatten als Ausschuss auszusondern, da auf den Oberflächen dieser Platten Fäden oder Baumwollfasern, die sich von den Schutzhandschuhen abgelöst haben, haften bleiben, wodurch die Trägerplatte für das Aufbringen des empfindlichen Filmes sofort unbrauchbar wird. Der Auftrag dieses Filmes, wie bereits vorher beschrieben, erfolgt in einer bekannten Filmaufwalzeinrichtung.

Aufgabe der vorstehenden Erfindung ist es, die Nachteile des Standes der Technik zu vermeiden und eine Einrichtung vorzuschlagen, mit der ohne mit der Oberfläche der aufgestapelten Platten in Kontakt zu kommen, eine automatische, schnelle Zuführung dieser Platten mit Präzision und Sicherheit an eine Filmaufwalzeinrichtung möglich wird.

Diese Aufgabe wird erfindungsgemäss dadurch gelöst, dass über einem Trägerplattenstapel eine Halteeinrichtung vorgesehen ist, die in vertikaler Richtung gegenüber dem liegenden Plattenstapel hin- und herbewegbar ist, dass diese Halteeinrichtung zwei parallele, waagerechte Führungsstangen aufnimmt, die an ihren entgegengesetzten Enden betätigbare, horizontale Kolbenzylindereinheiten aufweisen, deren Kolbenstangen mit parallelen, in einer horizontalen Ebene angeordneten, zu den Führungsstangen senkrechten Querträgern verbunden sind, an deren freien Enden einstellbare Greifer vorgesehen sind, die, in waagerechter, zu den Querträgern senkrechter Richtung, sowie in vertikaler Richtung gegenüber den zugehörigen Querträgern bewegbar, elastisch nachgiebig gelagert sind, und die dazu ausgebildet sind, zwischen sich jeweils eine Trägerplatte an deren Seitenkantenflächen festzuhalten, und dass parallel zu jedem der beiden waagrecht angeordneten Querträger, der die Greifer trägt, je ein betätigbarer und verschiebbarer Rollengang vorgesehen ist, wobei die beiden Rollengänge in einer waagrechten Ebene aus einer Ruhelage in eine Arbeitsstellung aufeinander und auf die dazwischen befindliche Trägerplatte zu, und zurück bewegbar sind, in welcher Arbeitsstellung den Rollengängen die Trägerplatten durch die Greifer übergeben und die Trägerplatten durch die an ihren Seitenkantenflächen angreifenden Rollengänge weitertransportiert werden.

Mit besonderem Vorteil sind die Greifer jeweils zwei parallel angeordneten Längskanten der Trägerplatte zugeordnet.

Es hat sich als vorteilhaft erwiesen, wenn diese Greifer von einer waagrecht angeordneten Führung und einer senkrechten angeordneten Führung aufgenommen werden, und diesen Führungsmitteln Federn zugeordnet sind, die sich der Bewegung in waagerechter und in senkrechter Richtung der Greifer, wenn diese mit den Kanten der Trägerplatte in Berührung kommen, entgegensetzen.

Es hat sich auch als vorteilhaft erwiesen, wenn der Hauptkörper des Greifers, auf der zur zu ergreifenden Trägerplatte hin gerichteten Seite, eine geneigte Ebene aufweist, mit der der Greifer auf der oberen Kante der Trägerplatte aufliegen kann, und dass an der Unterseite dieser geneigten Ebene ein scharfkantiger Vorsprung vorgesehen ist, mit dem die Trägerplatte ungefähr in der Mitte der senkrechten Kante, die die Dicke der Trägerplatte darstellt, festlegbar ist.

Weitere Vorteile der vorstehenden Erfindung können der nun folgenden Beschreibung, den weiteren Unteransprüchen und den Zeichnungen entnommen werden.

Die Erfindung wird nun anhand eines Ausführungsbeispieles genauer beschrieben und in den Zeichnungen schematisch dargestellt.

Fig. 1 zeigt schematisch in perspektivischer Ansicht die Greifergruppe.

Fig. 2 zeigt die Greifergruppe in Vorderansicht gemäss dem Pfeil II der Fig. 1.

Fig. 3 zeigt die Greifergruppe in einer Draufsicht.

Fig. 4 zeigt schematisch die den Greifergruppen zugeordneten Rollengänge.

Fig. 5–12 zeigen schematisch die verschiedenen Bewegungsabläufe der Greifer, sowie die der Rollengänge, zum Ergreifen und Transportieren einer Trägerplatte.

Fig. 13 zeigt schematisch ein Detail des Greifers mit der geneigten Fläche, die auf der oberen Kante einer Trägerplatte aufliegt, sowie mit dem scharfkantigen Vorsprung, der mit der senkrechten Plattenkante in Wirkverbindung tritt.

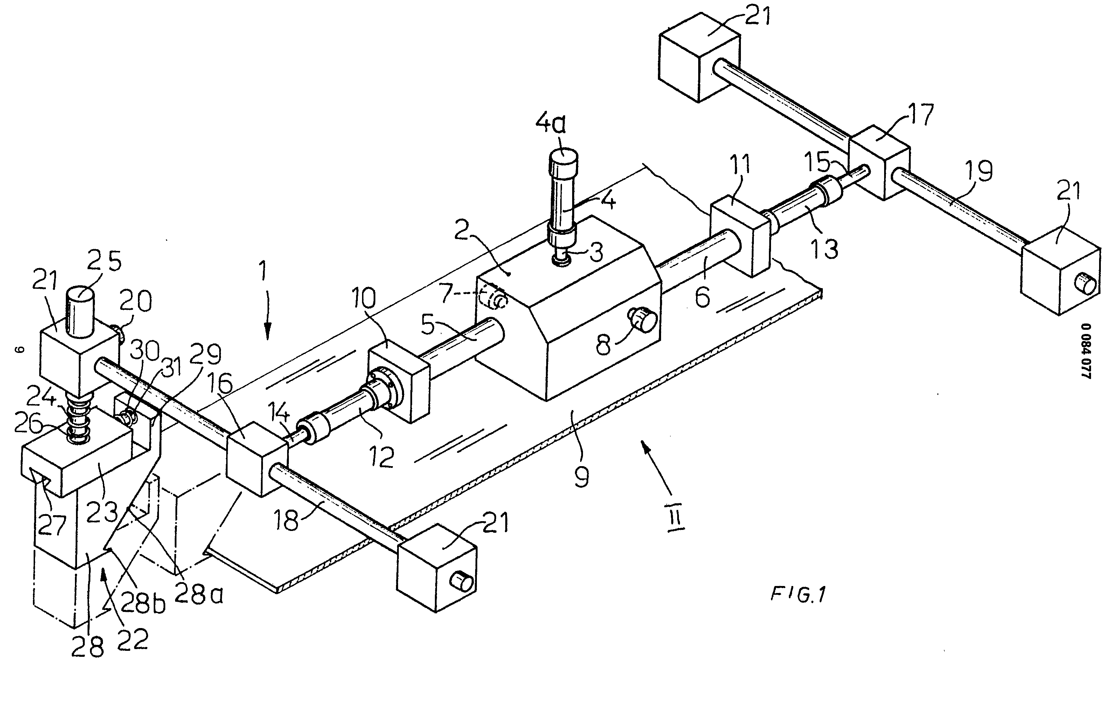

Wie der Fig. 1 zu entnehmen ist, besteht die insgesamt mit 1 gekennzeichnete, erfindungsgemässe Einrichtung, aus einem Traggehäuse 2, das mit der Kolbenstange 3 eines Pneumatikzylinders 4 oder einem ähnlichen Antriebsmittel wirkverbunden ist. Das Ende 4a des Pneumatikzylinders ist z.B. mit einem nicht dargestellten Tragegestell der Maschine verbunden.

Das Traggehäuse 2 nimmt in waagerechten, parallelen Bohrungen Führungsstangen 5 und 6 auf, die gegenüber dem Gehäuse 2 verschiebbar sind und in der gewünschten Stellung, z.B. durch Rändelkopfschrauben 7 und 8, festlegbar sind. Die Möglichkeit, die Haltestangen 5 und 6 zu verschieben, erweist sich als besonders vorteilhaft beim Einstellen und Ausrichten dieser Stangen, unter Berücksichtigung der Abmessungen der aufzunehmenden Trägerplatte 9. An den Enden weisen die verschiebbaren Haltestangen 5 und 6 Verdikkungen 10, 11 auf, die den Befestigungsflansch einer entsprechenden Kolbenzylindereinheit 12, 13 aufnehmen. Die Kolbenstangen 14, 15 der Kolbenzylindereinheiten 12, 13 sind mit weiteren Halterungen 16 und 17 wirkverbunden, die eine entsprechende horizontal angeordnete Querstrebe 18 bzw. 19 aufnehmen. An diesen Querstreben sind Halteklötze 21 angeordnet, die z.B. unter Verwendung von Halteschrauben 20, einstellbar und in ihrer Lage festlegbar sind. Durch die Möglichkeit, die Halteblöcke 21 längs der Querstreben 18 und 19 zu verfahren, ist es wiederum möglich, die Halterungen 21, unter Berücksichtigung der Abmessungen der Trägerplatte 9, einzustellen. Jede Halterung 21 ist mit einem Greifer ausgerüstet, der als Ganzes in der Fig. 1 mit 22 bezeichnet ist. In der Darstellung gemäss Fig. 1, ist aus Gründen der Übersichtlichkeit nur eine Greifeinheit 22 dargestellt, doch ist es einleuchtend, dass alle Halteblöcke 21 mit solchen Greifern 22 ausgerüstet sind.

Wie genauer aus der Fig. 1 zu entnehmen ist, besteht die Greifereinheit 22 aus einer Trageplatte 23, die über einen senkrechten Bolzen 24 in einer senkrechten Führungshülse 25, die im Halteblock angeordnet ist, gleitet.

Zwischen der Gleithülse 25 und der Trageplatte 23 ist auf dem Bolzen 24 eine Druckfeder 26 angeordnet, die es der Halteplatte 23 ermöglicht, eine senkrechte Bewegung in vertikaler Richtung, durch Überwinden der Federkraft des Federmittels 26, durchzuführen. An der Unterseite weist die Halteplatte 23 in vorteilhafter Weise eine Schwalbenschwanznut 27 auf, und in dieser Nut 27 gleitet ein entsprechendes Gegenprofil, das einstückig mit dem Greifer 28 ausgeführt ist. Der Greifer 28 weist an seiner Oberseite eine senkrechte Platte 29 auf, die einen Bolzen 33 aufnimmt, der verschiebbar in der horizontal angeordneten Platte 23 geführt ist, und, zwischen dieser Trägerplatte 23, sowie den vertikalen Vorsprüngen 29, ist eine Druckfeder 31 vorgesehen, um zu ermöglichen, dass der Greifer 28 eine Bewegung in waagerechter Richtung, gegen die Kraft der Feder 31 durchführen kann.

Auf der Vorderseite weist der Greifer 28 eine geneigte Ebene 28a auf, die an der Unterseite im zugespitzten Vorsprung 28b endet. Der Zweck dieser Bauelemente wird noch genauer in der folgenden Beschreibung dargestellt werden.

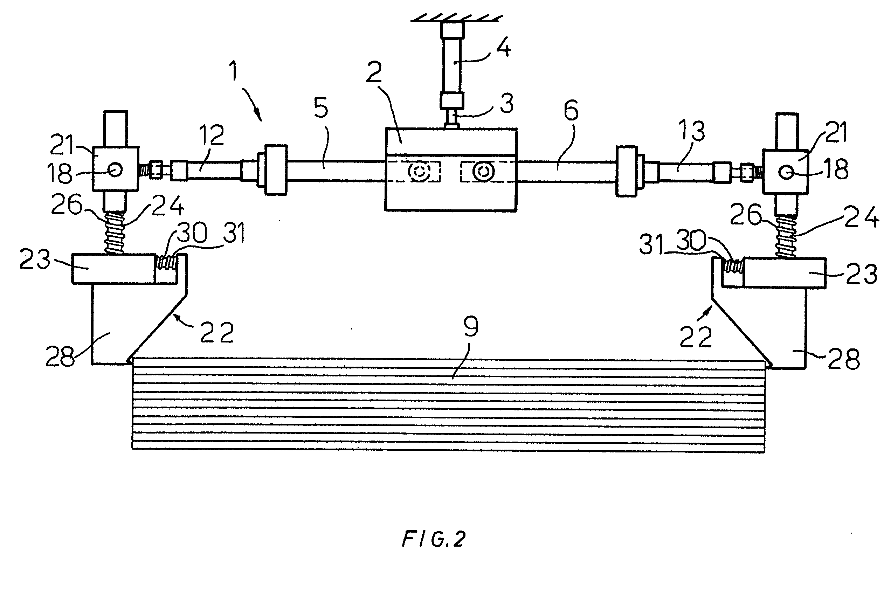

Aus der Fig. 2 können im Wesentlichen, die bereits anhand der Fig. 1 beschriebenen Bauteile entnommen werden, es wird jedoch die Stellung des Greifers 1 gegenüber der Trägerplatte 9, die unter der Vorrichtung 1 aufgestapelt sind, genauer dargestellt. In vorteilhafter Weise befindet sich der Plattenstapel 9 auf einem Hubtisch, der eine definierte Bewegung in senkrechter Richtung ausführen kann, wodurch gewährleistet wird, dass sich die oberste Platte 9 stets in gleicher Höhe gegenüber den Greifern 28 befindet, und zwar, in Übereinstimmung mit der geneigten Ebene 28a und den zugespitzten Vorsprüngen 28b.

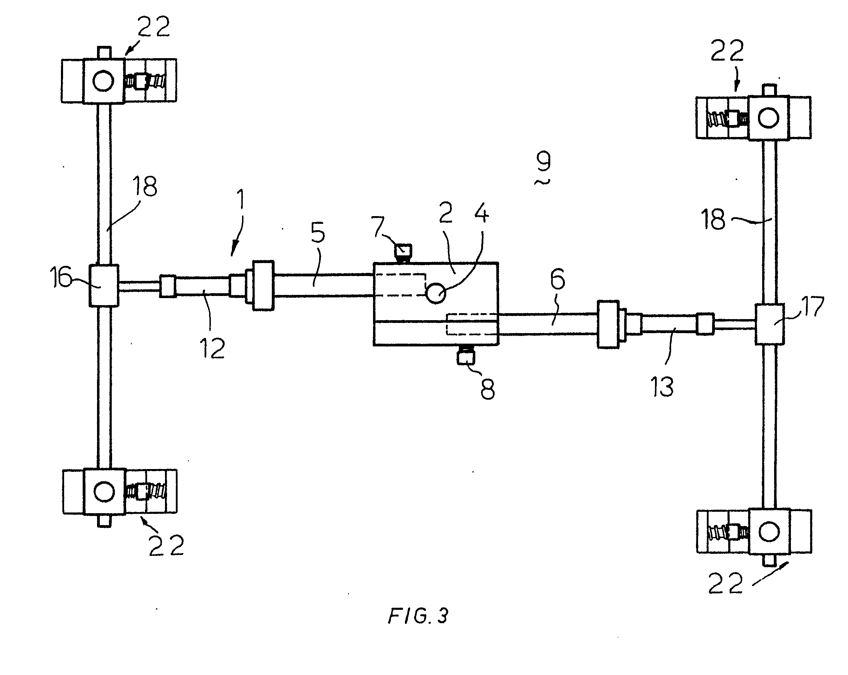

Aus der Fig. 3 kann noch einmal in einer Draufsicht die Abhebevorrichtung 1, sowie die Anordnung und Ausführung der Greifer 22, sowie deren Anordnung gegenüber dem Plattenstapel 9, entnommen werden.

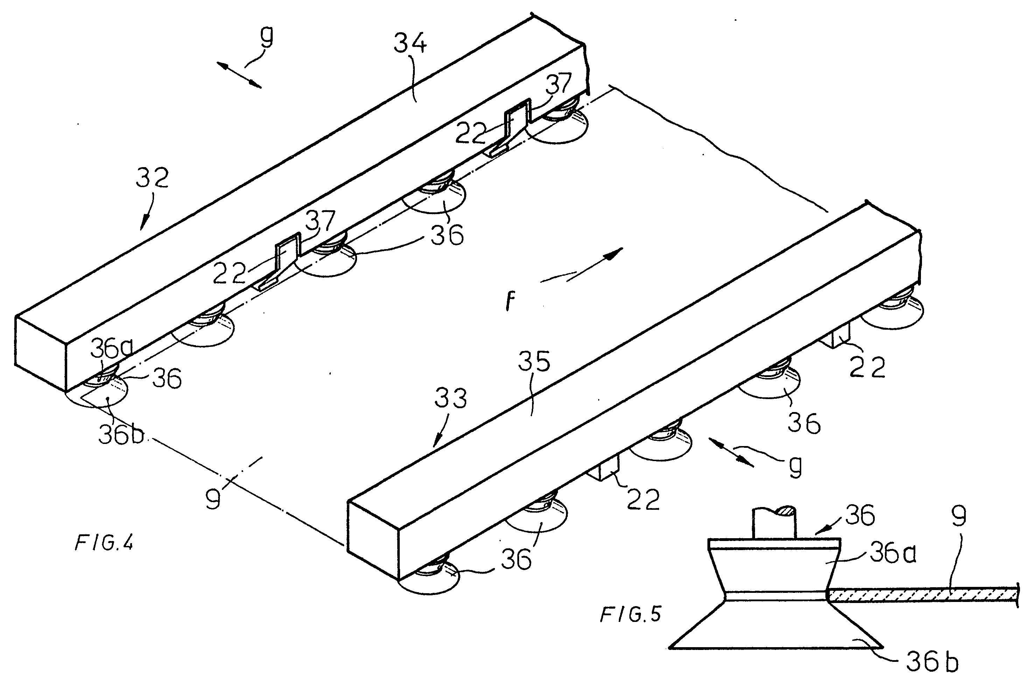

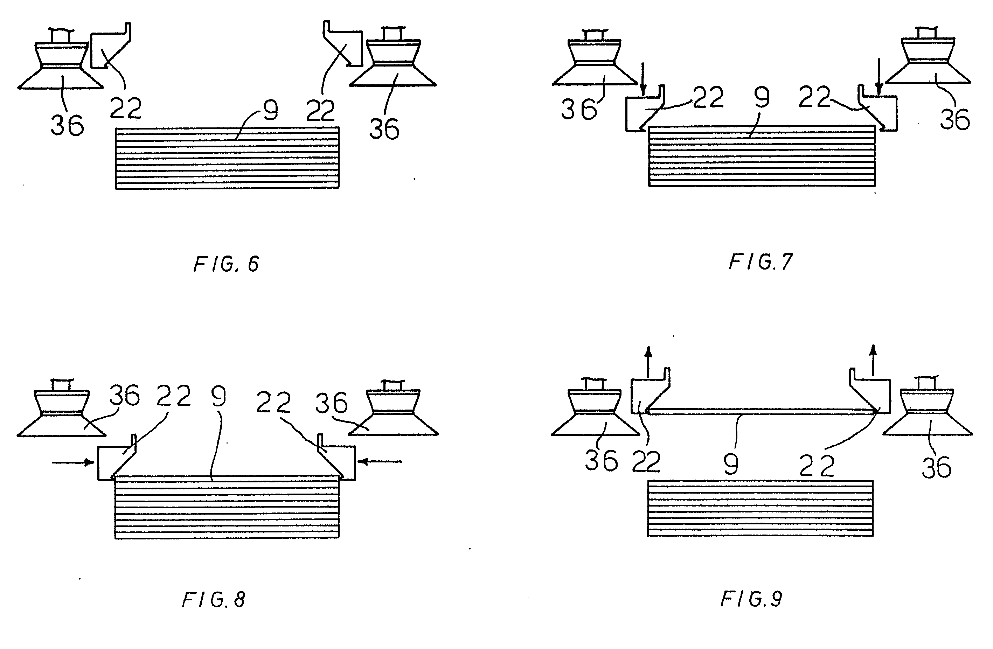

Für die Arbeitsweise der Vorrichtung 1, ist es erforderlich, dass dieser zwei Rollengänge zugeordnet sind, die in einer horizontalen Ebene bewegbar sind, wobei jeweils zwei Rollengänge parallel angeordneten Querstreben zugeordnet sind. Aus Gründen der Übersichtlichkeit, wurden in den Fig. 1–3 diese Rollengänge nicht dargestellt, ihre Ausbildung kann genauer den Fig. 4 und 5 entnommen werden.

In der Fig. 4 sind zwei angeordnete horizontale Rollengänge dargestellt, die der Vorrichtung 1 zugeordnet sind und in dieser bildlichen Darstellung sind lediglich Greifergruppen 22 gezeigt, wogegen die einzelnen Haltevorrichtungen, Kolbenzylindereinheiten und Tragemittel, aus Gründen der Übersichtlichkeit nicht dargestellt wurden.

Wie vorher bereits ausgeführt, sind parallel zu den Querstreben 18 und 19, Rollengänge 32 und 33 vorgesehen, die in Gehäusen 34 bzw. 35, die z.B. vom nicht dargestellten Maschinengestell aufgenommen werden, eine Anzahl von Rollen aufnehmen, die mit ihren Drehachsen in den Gehäusen 34 und 35 gelagert sind, und derartig angetrieben werden, dass die Trageplatte 9 in Richtung des Pfeiles f fortbewegt wird.

Die Rollen 36 weisen in vorteilhafter Weise die Form von zwei Kegelstümpfen 36a und 36b auf, die mit ihren verjüngten Teilstücken zusammengefügt sind, wobei diese Verbindung ungefähr auf der Höhe der Trägerplatte 9 vorgesehen ist. Die Gehäuse 32 und 33, die in horizontaler Richtung beweglich angeordnet sind, weisen ferner Öffnungen 37 auf, in die die Greifergruppen 22 während der Bewegung der Rollenbahnen 32 und 33 in einer horizontalen Ebene, wie dies durch die Doppelpfeile g angedeutet ist, eintreten können. Um den Rollenbahnen 32, 33 diese Bewegung erteilen zu können, sind die Rollenbahnen in vorteilhafter Weise mit Kolbenzylindereinheiten ausgerüstet, die beispielsweise über Druckluft betätigbar sind und fest am Rahnengestell der Maschine (nicht dargestellt) angeordnet sind.

Aus der Fig. 5 kann ein Detail einer Rolle 36 mit den geneigten Flächen 36a und 36b entnommen werden. Mit dieser besonderen Ausführungsform der Rolle wird gewährleistet, dass die Platten 9, wenn diese von den Greifern 22 freigegeben werden, in Richtung des Pfeiles (f) durch die angetriebenen Rollen 36 weiterbefördert werden können. Somit treten die Platten 9 lediglich mit den Rollen 36 über die entsprechende untere Eckkante mit der geneigten Fläche 36b, oder die obere Eckkante mit der geneigten Fläche 36a, in Wirkverbindung.

Die Arbeitsweise der erfindungsgemässen Vorrichtung 1, 32, 33, wird nun anhand eines schematisch dargestellten Bewegungsablaufes anhand der Fig. 6–12 genauer dargestellt und beschrieben.

In der Fig. 6 sind die Greifer 22 bereits über dem Plattenstapel 9 angeordnet, der sich unter den Greifern befindet, und die Rollen 36 der Rollenbahnen 32 bzw. 33 sind auf maximalen Abstand gestellt. Durch Betätigen der Kolbenzylindereinheit 3, 4, werden alle Greifer 22 nach unten auf den Plattenstapel zubewegt, wodurch die geneigten Flächen 28b der Greifer 22 mit den oberen, parallel zueinander laufenden Eckkanten der obersten Platte 9 in Verbindung treten (Auflage). Dank der Möglichkeit, eine elastische Bewegung in vertikaler Richtung (Führungsstange 24 und Feder 26) durchzuführen, erfolgt der Kontakt zwischen den geneigten Flächen 28a und den oberen Eckkanten der obersten Platte 9 allmählich, sanft und mit Sicherheit, auch im Falle verworfener Platten, da durch diese Verschiebemöglichkeit in vertikaler Richtung, auch Unregelmässigkeiten der Platte 9 in Bezug auf die waagerechte Ebene, ausgeglichen werden.

Nachdem die Greiferelemente 22, wie dies in der Fig. 7 dargestellt ist, über ihre geneigten Ebenen 28b mit den oberen Eckkanten der obersten Trägerplatte 9 in Verbindung getreten sind, werden die Kolbenzylindereinheiten 12, 14 und 13, 15 derartig angetrieben, dass die Greifer 22 in Richtung der Haltestütze, die mit der Kolbenzylindereinheit 3, 4 verbunden ist, verschoben werden, wodurch die zugespitzten Vorsprünge 28b, wie dies in Fig. 8 dargestellt ist, in Wirkverbindung mit den senkrechten, parallelen Längskanten der obersten Trägerplatte 9 treten. Auch in diesem Fall hat es sich als vorteilhaft erwiesen, dass jedes Greiferelement 28 eine elastische Bewegung in horizontaler Richtung ausführen kann. Dies wird durch die Vorsehung der Schwalbenschwanzführung 27, der Führungsstange 30, sowie der Druckfeder 31 ermöglicht, die zwischen dem Träger 23 und dem Vorsprung 29 des Greifkörpers 28 angeordnet ist. Dank dieser federnden Lagerung wird die oberste Trägerplatte 9 von den zugespitzten Vorsprüngen 28b auch im Falle nicht genau zugeschnittener Platten, die u.U. einen unregelmässigen Umfang aufweisen, ergriffen. Nachdem die obere Trägerplatte 9 durch die Greifer 22 festgelegt wurde, wie dies in Fig. 8 dargestellt ist, wird die Kolbenzylindereinheit 3, 4 erneut angetrieben, um die Platte, wie in Fig. 9 dargestellt, bis in eine Ebene, die ungefähr der Einschnürung der Rolle 36 entspricht und zwischen den Kegelstümpfen 36a und 36b gebildet ist, anzuheben.

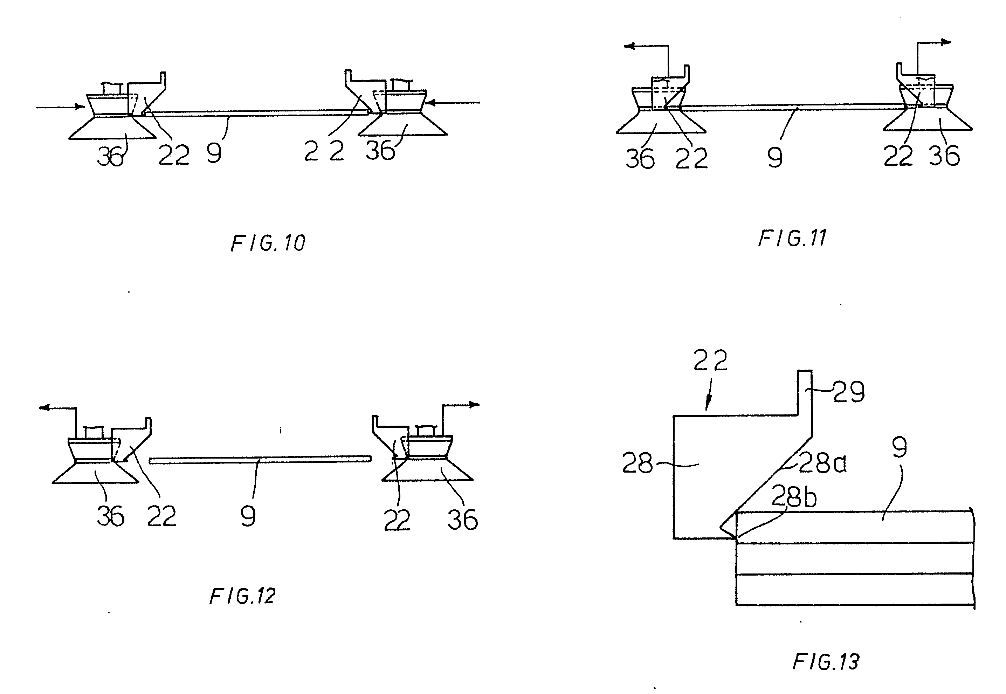

Wenn diese Stellung, wie in Fig. 9 dargestellt ist, erreicht wurde, so werden auch die Rollenbahnen 32 bzw. 33 in horizontaler Ebene verschoben und in Richtung der von den Greifern 22 blockierten Trägerplatte 9 bewegt. In diesem Falle, können die Greifer 22 in die dafür vorgesehenen Öffnungen 37 der Gehäuse 34 und 35 eintreten, wie dies schematisch in Fig. 4 dargestellt ist. Im Anschluss werden die Kolbenzylindereinheiten 12, 14 und 13, 15 erneut angetrieben, und die Greifer 22 werden untereinander auf Abstand gebracht, wie dies in Fig. 11 dargestellt ist. Dadurch wird die vorher durch die Greifer gehaltene Trägerplatte 9 freigegeben und an die untere geneigte Ebene 36b der angetriebenen Rollen 36 übergeben, wodurch die Trägerplatte 9 den Beschickungsmitteln der Filmaufwalzeinrichtung (nicht dargestellt), die am Ende der Rollengänge 32 und 33 angeordnet ist, zugeführt wird. Im Anschluss werden auch die Rollengänge 32 und 33 erneut auf Abstand gebracht, wie dies in Fig. 12 dargestellt ist.

Aus der bisherigen Beschreibung kann entnommen werden, dass es mit der beschriebenen Vorrichtung erstmals möglich wurde, Trägerplatten für gedruckte Schaltungen automatisch und mit der notwendigen Sicherheit und Vorsicht von einem Plattenstapel abzuheben, und diese Platten einer Filmaufwalzeinrichtung zuzuführen, ohne dass dabei die empfindlichen Oberflächen dieser Platten 9 berührt und dadurch beschädigt werden würden.

Der Fig. 13 kann in vergrössertem Massstab die besondere Ausführungsform des Greifers 22 entnommen werden. Der Greifer 22 tritt während seiner Abwärtsbewegung in senkrechter Richtung, zuerst mit der oberen Eckkante der obersten Platte 9 in Berührung und liegt mit seiner geneigten Fläche 28b auf dieser Eckkante auf. Im Anschluss daran, während einer weiteren Bewegung in horizontaler Richtung der Greiferelemente 22, tritt der zugespitzte Vorsprung 28b mit der zugeordneten senkrechten Kante der Platte 9 in Verbindung und klemmt die Platte somit fest.

Mit dieser besonderen Ausführungsform des Greifers 22 wird eine vorteilhafte Kombination zwischen formschlüssiger und kraftschlüssiger Festlegung der Trägerplatte 9 zwischen den Greifern 22 erzielt und die Trägerplatte 9 kann somit schnell mit Sicherheit angehoben werden, um, unter Zuhilfenahme der vorher beschriebenen Rollengänge, die in horizontaler Richtung beweglich angeordnet sind, einer anschliessenden Filmaufwalzeinrichtung zugeführt zu werden, die auf der Trägerplatte einen fotoempfindlichen Film aufbringt.

Für diesen Beschickungsvorgang ist kein Bedienungspersonal erforderlich, und die Greifer berühren niemals die empfindlichen Oberflächen der Trägerplatte 9.

Es ist einleuchtend, dass durch die Vorsehung der erfindungsgemässen Vorrichtung eine erhebliche Verkleinerung der klimatisierten Räume, in denen die Stapel der zu beschickenden Trägerplatten 9 vorgesehen sind, möglich ist, wobei diese klimatisierten Räume vollständig abgekapselt sein können.

**Patentansprüche**

1. Vorrichtung zum automatischen Beschicken einer Filmaufwalzeinrichtung mit Trägerplatten für gedruckte Schaltungen, dadurch gekennzeichnet, dass über einem Trägerplattenstapel (9) eine Halteeinrichtung (2) vorgesehen ist, die in vertikaler Richtung gegenüber dem liegenden Plattenstapel (9) hin- und herbewegbar ist, dass diese Halteeinrichtung (2) zwei parallele, waagerechte Führungsstangen (5, 6) aufnimmt, die an ihren entgegengesetzten Enden betätigbare, horizontale Kolbenzylindereinheiten (12, 13) aufweisen, deren Kolbenstangen (14, 15) mit parallelen, in einer horizontalen Ebene angeordneten, zu den Führungsstangen senkrechten Querträgern (18, 19) verbunden sind, an deren freien Enden einstellbare Greifer (22) vorgesehen sind, die, in waagerechter, zu den Querträgern senkrechter Richtung (30, 31), sowie in vertikaler (24, 26) Richtung gegenüber den zugehörigen Querträgern bewegbar, elastisch nachgiebig gelagert sind, und die dazu ausgebildet sind, zwischen sich jeweils eine Trägerplatte an deren Seitenkantenflächen festzuhalten, und dass parallel zu jedem der beiden waagerecht angeordneten Querträger (18, 19), der die Greifer (22) trägt, je ein betätigbarer und verschiebbarer Rollengang (32, 33) vorgesehen ist, wobei die beiden Rollengänge in einer waagerechten Ebene (9) aus einer Ruhelage in eine Arbeitstellung aufeinander und auf die dazwischen befindliche Trägerplatte zu, und zurück bewegbar sind, in welcher Arbeitsstellung den Rollengängen (32, 33) die Trägerplatten (9) durch die Greifer übergeben und die Trägerplatten durch die an ihren Seitenkantenflächen angreifenden Rollengänge weitertransportiert werden.

2. Vorrichtung nach Patentanspruch 1, dadurch gekennzeichnet, dass die Greifer (22) jeweils zwei parallelen Längsseiten einer zu transportierenden Trägerplatte (9) zugeordnet sind.

3. Vorrichtung nach Patentanspruch 1, dadurch gekennzeichnet, dass jeder einzelne Greifer (22) eine horizontal angeordnete Führung (27, 30, 31) und eine vertikal angeordnete Führung (24, 26) aufweist, und dass diesen Führungen Federmittel (31, 26) zugeordnet sind, die einer Bewegung des Greifers (22) in horizontaler sowie in vertikaler Richtung entgegenwirken, wenn dieser mit den Kanten einer Trägerplatte (9) in Verbindung tritt.

4. Vorrichtung nach Patentanspruch 1 und 3, dadurch gekennzeichnet, dass der Greifer (22) auf seiner der zu erfassenden Platte (9) zugewendeten Seite eine schiefe Ebene (28a) aufweist, mit der der Greifer (22) an der oberen Kante der Platte (9) bei seiner Absenkbewegung aufliegt und dass die Unterseite der schiefen Ebene (28a) in einem zugespitzten Vorsprung (28b) ausläuft, der zur Platte (9) hin gerichtet ist, und zum Festhalten der Platte (9) in der Mitte der die Plattendicke bildenden senkrechten Seitenkantenflächen ausgebildet ist.

5. Vorrichtung nach Patentanspruch 1, dadurch gekennzeichnet, dass die Halteeinrichtung (2) mit der antriebbaren Kolbenstange (3) einer vertikalen Kolbenzylindereinheit (4) verbunden ist, und dass die vertikale Kolbenzylindereinheit (4) am Maschinenrahmen (4a) befestigt ist.

6. Vorrichtung nach Patentanspruch 1, dadurch gekennzeichnet, dass die Halteeinrichtung (2) in waagrecht angeordneten parallelen Bohrungen die Führungsstangen (5, 6) aufnimmt, dass diese gegenüber dem Gehäuse (2) verschiebbar sind und in der gewünschten Lage durch Feststellschrauben (7, 8) festlegbar sind.

7. Vorrichtung nach Patentanspruch 1, dadurch gekennzeichnet, dass jede einstellbare Führungsstange (5, 6) an ihren freien Enden eine Verdikkung (10, 11) aufweist, die den Flansch einer der horizontalen Kolbenzylindereinheiten (12, 13) aufnimmt.

8. Vorrichtung nach Patentanspruch 1 und 7, dadurch gekennzeichnet, dass die Querträger (18, 19) Haltelager (21) tragen, die auf den Querträgern (18, 19) verschiebbar und in ihrer gewünschten Stellung durch Feststellschrauben (20) festlegbar sind, und dass jedes dieser Haltelager (21) einen der Greifer (22) trägt.

9. Vorrichtung nach Patentanspruch 1, 7 und 8, dadurch gekennzeichnet, dass jedes Haltelager (21) eine vertikale Führung (25) aufweist, die einen Gleitbolzen (24) aufnimmt, der fest mit dem Greifer (22) verbunden ist, und dass zwischen dem Haltelager (21) und dem Greifer (22) das vertikal wirkende Federmittel (26) angeordnet ist.

10. Vorrichtung nach Patentanspruch 1, 2, 3 und 4, dadurch gekennzeichnet, dass der Greifer (22) aus einer horizontalen Trageplatte (23) besteht, die eine Führungsnut (27) aufweist, dass in dieser Nut (27) eine Greiferelement (28) verschiebbar gelagert ist, das mit einer schiefen Ebene (28a) versehen ist, und dass zwischen der horizontalen Trageplatte (23) und dem Greiferelement (28) mit der schiefen Ebene (28a) ein Federmittel (31) angeordnet ist, das von einem horizontal angeordneten Führungsstift (30) geführt ist, der verschiebbar in der horizontalen Trageplatte (23) angeordnet ist.

11. Vorrichtung nach Patentanspruch 1, dadurch gekennzeichnet, dass die bewegbaren Rollengänge (32, 33) vom Maschinengestell getragen werden.

12. Vorrichtung nach Patentanspruch 1 und 11, dadurch gekennzeichnet, dass die Rollen (36) der Rollengänge die Form von jeweils zwei Kegelstümpfen (36a, 36b) aufweisen, die mit ihren sich verjüngenden Enden zusammengefügt sind.

13. Vorrichtung nach Patentanspruch 1 und 11, dadurch gekennzeichnet, dass die Rollengänge (32) Gehäuse (34, 35) aufweisen, die auf der den Greifern (22) zugewandten Seite Öffnungen (37) zum Eintritt der Greifer (22) in das Innere der Gehäuse (34, 35) aufweisen.

## Claims

1. Apparatus for automatically charging a film coater with boards for printed circuits, characterised in that a holder means (2) is provided above a stack of boards (9) and is adapted to reciprocate vertically with respect to the horizontal stack (9); said holder means (2) accommodates two parallel horizontal guide bars (5, 6) having at their opposite ends operable horizontal piston-and-cylinder units (12, 13), the piston rods (14, 15) of which are connected to parallel cross-members (18, 19) which are disposed in a horizontal plane, are perpendicular to the guide bars, and have adjustable grippers (22) at their free ends, said grippers being mounted to be elastically resiliently movable in a horizontal direction (30, 31) perpendicular to the cross-members and in a vertical direction (24, 26) with respect to the associated cross-members, said grippers also being constructed to hold a board between them at the board side edge surfaces; and an operable and slidable roller table (32, 33) is provided parallel to each of the two horizontal cross-members (18, 19) bearing the grippers (22), the two roller tables being movable in a horizontal plane (9) out of an inoperative position into an operative position towards one another and towards the board situated therebetween, and back, in which operative position the boards (9) are transferred by the grippers to the roller tables (32, 33) and the boards are conveyed on by the roller tables engaging their side edge surfaces.

2. Apparatus according to claim 1, characterised in that the grippers (22) are each associated with two parallel longitudinal sides of a board (9) requiring to be conveyed.

3. Apparatus according to claim 1, characterised in that each individual gripper (22) has a horizontal guide (27, 30, 31) and a vertical guide (24, 26), and said guides are associated with spring means (31, 26) which counteract movement of the gripper (22) in the horizontal and vertical directions when the gripper comes into contact with the edges of a board (9).

4. Apparatus according to claims 1 and 3, characterised in that the gripper (22) has an inclined plane (28a) on its side facing the board (9) requiring to be engaged, the gripper (22) bearing on the top edge of the board (9) by said inclined plane (28a) during its downward movement; and the underside of the inclined plane (28a) terminates in a pointed projection (28b), which is directed towards the board (9) and which is designed to retain the board (9) in the middle of the vertical side edge surfaces forming the board thickness.

5. Apparatus according to claim 1, characterised in that the holder means (2) is connected to the drivable piston rod (3) of a vertical piston-and-cylinder unit (4); and the vertical piston-and-cylinder unit (4) is fixed to the machine frame (4a).

6. Apparatus according to claim 1, characterised in that the holder means (2) accommodates the guide bars (5, 6) in horizontal parallel bores; the guide bars are displaceable with respect to the housing (2) and are lockable in the required position by locking screws (7, 8).

7. Apparatus according to claim 1, characterised in that each adjustable guide bar (5, 6) has a thickening (10, 11) at its free ends to accommodate the flange of one of the horizontal piston-and-cylinder units (12, 13).

8. Apparatus according to claims 1 and 7, characterised in that the cross-members (18, 19) bear retaining bearings (21) which are displaceable on the cross-members (18, 19) and are lockable in their required position by locking screws (20); and each of these retaining bearings (21) bears one of the grippers (22).

9. Apparatus according to claims 1, 7 and 8, characterised in that each retaining bearing (21) has a vertical guide (25) receiving a sliding pin (24) fixed to the gripper (22); and the vertically acting spring means (26) is disposed between the retaining bearing (21) and the gripper (22).

10. Apparatus according to claims 1, 2, 3 and 4, characterised in that the gripper (22) consists of a horizontal plate (23) with a guide groove (27); a gripper element (28) is slidably mounted in said groove (27) and has an inclined plane (28a); and a spring means (31) is disposed between the horizontal board (23) and the gripper element (28) having the inclined plane (28a), said spring means being guided by a horizontal guide pin (30) slidable in the horizonal plate (23).

11. Apparatus according to claim 1, characterised in that the movable roller tables (32, 33) are carried by the machine frame.

12. Apparatus according to claims 1 and 11, characterised in that the rollers (36) of the roller tables are each in the form of two frusto-conical members (36a, 36b) joined by their tapering ends.

13. Apparatus according to claims 1 and 11, characterised in that the roller tables (32) have housings (34, 35) which, on the side facing the grippers (22), have apertures (37) for the entry of the grippers (22) into the interior of the housings (34, 35).

## Revendications

1. Dispositif de chargement automatique d'un mécanisme de laminage de pellicule en plaques de substrat pour circuits imprimés, caractérisé en ce qu'il est prévu au-dessus d'une pile (9) de plaques de substrat un dispositif de retenue (2) qui peut effectuer des mouvements de va-et-vient en direction verticale par rapport à la pile de substrats (9) immobile, en ce que ce dispositif de retenue (2) loge deux tiges de guidage horizontales parallèles (5, 6) qui comportent à leurs extrémités opposées des ensembles piston-cylindre horizontaux actionnables (12, 13) dont les tiges de piston (14, 15) sont reliées à des traverses (18, 19) placées dans un plan horizontal, orthogonales aux tiges de guidage, aux extrémités libres desquelles sont prévues des griffes (22) qui sont montées avec un appui élastiquement flexible de façon à pouvoir se déplacer dans une direction horizontale (30, 31) orthogonale aux traverses, ainsi qu'en direction verticale (24, 26) par rapport aux traverses correspondantes, et qui sont conformées de façon à immobiliser entre elles, dans chaque cas, une plaque de substrat respective au contact des surfaces de leurs bords latéraux, et en ce qu'il est prévu parallèlement à chacune des deux traverses (18, 19) disposées horizontalement, qui porte les griffes (22), un jeu de rouleaux (32, 33) respectif pouvant être actionné et déplacé, les deux jeux de rouleaux pouvant passer, dans un plan horizontal (9), d'une position de repos à une position de travail en se rapprochant l'un de l'autre et de la plaque de substrat intercalée, et inversement, position de travail dans laquelle les plaques de substrat (9) sont transférées aux jeux de rouleaux (32, 33) et les plaques de substrat sont transportées en aval par les jeux de rouleaux s'appliquant aux surfaces de leurs bords latéraux.

2. Dispositif selon la revendication 1, caractérisé en ce que les griffes (22) sont rattachées respectivement à deux grands côtés parallèles d'une plaque de substrat (9) à transporter.

3. Dispositif selon la revendication 1, caractérisé en ce que chaque griffe individuelle (22) comporte un guide (27, 30, 31) disposé horizontalement et un guide (24, 26) disposé verticalement, et en ce qu'il est rattaché à ces guides des organes élastiques (31, 26) qui s'opposent à un déplacement de la griffe (22) en direction horizontale, ainsi qu'en direction verticale, lorsque celle-ci entre en liaison avec les bords d'une plaque de substrat (9).

4. Dispositif selon les revendications 1 et 3, caractérisé en ce que la griffe (22) comporte, sur sa face située du côté de la plaque (9) à saisir, un plan incliné (28a) par lequel la griffe (22) repose sur le bord supérieur de la plaque (9) lors de son mouvement de descente, et en ce que la face inférieure du plan incliné (28a) s'achève par une saillie pointue (28b), dirigée vers la plaque (9), et conformée pour immobiliser la plaque (9) au centre des surfaces verticales des bords latéraux formant l'épaisseur de la plaque.

5. Dispositif selon la revendication 1, caractérisé en ce que le dispositif de retenue (2) est relié à la tige de piston pouvant être entraînée (3) d'un ensemble piston-cylindre (4) vertical, et en ce que l'ensemble piston-cylindre (4) est fixé au bâti (4a).

6. Dispositif selon la revendication 1, caractérisé en ce que le dispositif de retenue (2) reçoit dans des alésages parallèles disposés horizontalement les tiges de guidage (5, 6), et en ce que celles-ci peuvent coulisser par rapport au dispositif de retenue ou boîtier (2), et en ce qu'elles peuvent être immobilisées dans la position souhaitée par des vis de blocage (7, 8).

7. Dispositif selon la revendication 1, caractérisé en ce que chaque tige de guidage ajustable (5, 6) comporte, à ses extrémités libres, un épaississement (10, 11) qui reçoit la bride de l'un des ensembles piston-cylindre horizontaux (12, 13).

8. Dispositif selon les revendications 1 et 7, caractérisé en ce que les traverses (18, 19) portent des supports de retenue (21) mobiles sur les traverses (18, 19) et qui peuvent être fixés dans leur position souhaitée par des vis de blocage (20), et en ce que chacun de ces supports de retenue (21) porte l'une des griffes (22).

9. Dispositif selon les revendications 1, 7 et 8, caractérisé en ce que chaque support de retenue (21) comporte un guide vertical (25) qui reçoit une cheville de guidage mobile (24) reliée rigidement à la griffe (22), et en ce que l'organe élastique à action verticale (26) est placé entre le support de retenue (21) et la griffe (22).

10. Dispositif selon les revendications 1, 2, 3 et 4, caractérisé en ce que la griffe (22) comprend une plaque de support horizontale (23) qui comporte une rainure de guidage (27), en ce qu'un élément de griffe (28) comportant un plan incliné (28a) est placé dans cette rainure (27) de façon à pouvoir coulisser, et en ce qu'un organe élastique (31) est placé entre la plaque de support horizontale (23) et l'élément de griffe (28) comportant le plan incliné (28a), organe élastique guidé par une broche de guidage (30) disposée horizontalement placée de façon à pouvoir coulisser dans la plaque de support horizontale (23).

11. Dispositif selon la revendication 1, caractérisé en ce que les jeux de rouleaux mobiles (32, 33) sont supportés par le bâti.

12. Dispositif selon les revendications 1 et 11, caractérisé en ce que les rouleaux (36) des jeux de rouleaux présentent chacun la forme de deux troncs de cône (36a, 36b) rassemblés par leurs extrémités convergentes.

13. Dispositif selon les revendications 1 et 11, caractérisé en ce que les jeux de rouleaux (32) comportent des boîtiers (34, 35) qui comportent, sur leur face située du côté des griffes (22), des ouvertures (37) permettant aux griffes (22) de pénétrer à l'intérieur des boîtiers (34, 35).

FIG.1

0 084 077

FIG.2

FIG. 3

FIG.4

FIG.5

0 084 077

FIG. 6

FIG.7

FIG. 8

FIG.9

0 084 077

FIG.10

FIG.11

FIG.12

FIG.13